(19) Europäisches Patentamt / European Patent Office / Office européen des brevets

(11) **EP 2 086 024 B1**

(12) **EUROPEAN PATENT SPECIFICATION**

(45) Date of publication and mention
of the grant of the patent:
**31.10.2018 Bulletin 2018/44**

(51) Int Cl.:
*H01L 31/078* *(2012.01)*   *H01L 31/0735* *(2012.01)*
*H01L 31/0687* *(2012.01)*   *H01L 31/0693* *(2012.01)*

(21) Application number: **09000718.8**

(22) Date of filing: **20.01.2009**

(54) **Heterojunction subcells in inverted metamorphic multijunction solar cells**

Heteroübertragungsunterzellen in umgekehrten metamorphischen Multiverbindungssolarzellen

Sous-cellules d'hétérojonction dans des cellules solaires multi-jonctions inversées métamorphiques

(84) Designated Contracting States:
**DE FR IT**

(30) Priority: **31.01.2008 US 23772**

(43) Date of publication of application:
**05.08.2009 Bulletin 2009/32**

(73) Proprietor: **SolAero Technologies Corp.**
**Albuquerque, NM 87123 (US)**

(72) Inventors:
• **Stan, Mark, A.**
**Albuquerque, NM 87122 (US)**
• **Cornfeld, Arthur**
**Sandia Park, NM 87047 (US)**

(74) Representative: **adares Patent- und**
**Rechtsanwälte**
**Reininger & Partner GmbB**
**Tauentzienstraße 7 b/c**
**10789 Berlin (DE)**

(56) References cited:
**US-A- 4 017 332**   **US-A1- 2004 084 694**
**US-A1- 2006 144 435**   **US-A1- 2007 277 873**

• SCHULTZ J C ET AL: "High efficiency 1.0 eV
GaInAs bottom solar cell for 3-junction
monolithic stack", 19900521; 19900521 -
19900525, 21 May 1990 (1990-05-21), pages
148-152, XP010003168,
• MARK WANLASS ET AL: "Monolithic, Ultra-Thin
GaInP/GaAs/GaInAs Tandem Solar Cells",
CONFERENCE RECORD OF THE 2006 IEEE 4TH
WORLD CONFERENCE ON PHOTOVOLTAIC
ENERGY CONVERSION (IEEE CAT.
NO.06CH37747), IEEE, 1 May 2006 (2006-05-01),
pages 729-732, XP031007408, ISBN:
978-1-4244-0016-4

## Description

BACKGROUND OF THE INVENTION

1. Field of the Invention

The present invention relates to the field of solar cell semiconductor devices, and particularly to multijunction solar cells including a metamorphic layer. Such devices also include solar cells known as inverted metamorphic multijunction solar cells.

2. Description of the Related Art

Photovoltaic cells, also called solar cells, are one of the most important new energy sources that have become available in the past several years. Considerable effort has gone into solar cell development. As a result, solar cells are currently being used in a number of commercial and consumer-oriented applications. While significant progress has been made in this area, the requirement for solar cells to meet the needs of more sophisticated applications has not kept pace with demand. Applications such as concentrator terrestrial power systems and satellites used in data communications have dramatically increased the demand for solar cells with improved power and energy conversion characteristics.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as the payloads become more sophisticated, solar cells, which act as the power conversion devices for the on-board power systems, become increasingly more important.

Solar cells are often fabricated in vertical, multijunction structures, and disposed in horizontal arrays, with the individual solar cells connected together in a series. The shape and structure of an array, as well as the number of cells it contains, are determined in part by the desired output voltage and current.

Inverted metamorphic solar cell structures such as described in M.W. Wanless et al., Lattice Mismatched Approaches for High Performance, III - V Photovoltaic Energy Converters (Conference Proceedings of the 31st IEEE Photovoltaic Specialists Conference, Jan. 3-7, 2005, IEEE Press, 2005) present an important conceptual starting point for the development of future commercial high efficiency solar cells. The structures described in such reference present a number of practical difficulties relating to the appropriate choice of materials and fabrication steps.

US 2007/0277873 A1 discloses an inverted triple junction solar having a heterojunction middle subcell.

Prior to the present invention, the materials and fabrication steps disclosed in the prior art have not been adequate to produce a commercially viable and energy efficient solar cell using an inverted metamorphic multijunction cell structure.

SUMMARY OF THE INVENTION

The invention is defined according to claim 1 (product) and claim 5 (process for manufacturing the product).

Briefly, and in general terms, the present invention provides multijunction solar cell including a bottom subcell having a bandgap in the range of 0.8 to 1.2 eV, a middle subcell having a base and an emitter, a band gap in the range of 1.2 to 1.6 eV, and being disposed over and being lattice mismatched to the bottom cell; and a top subcell having a base and emitter, a band gap in the range of 1.8 to 2.1 eV, and being disposed over and being lattice matched to the middle cell, wherein the base-emitter junctions in the middle and bottom subcell are heterojunctions.

In another aspect, the present invention provides a multi-junction solar cell including an upper first solar subcell having a base and an emitter and having a first bandgap; a middle second solar subcell having a second bandgap smaller than the first bandgap adjacent to the first solar subcell and having a heterojunction base and emitter; a graded interlayer adjacent to the second solar subcell, the graded interlayer having a third bandgap greater than the second bandgap; and a lower solar subcell adjacent to the graded interlayer, the lower subcell having a fourth bandgap smaller than the second bandgap such that the third subcell is lattice mismatched with respect to the second subcell.

In another aspect, the present invention provides a photovoltaic solar cell including a top subcell including base and emitter layers of InGaP semiconductor material; a middle subcell including a base layer of GaAs semiconductor material and a emitter layer of InGaP semiconductor material; and a bottom subcell including an emitter layer composed of InGaP and base layer composed of an InGaAs semiconductor material.

In another aspect, the present invention provides a multijunction solar cell including a first subcell comprising a first semiconductor material with a first bandgap and a first lattice constant; a second subcell comprising a second semiconductor material with heterojunction base and emitter, and a second bandgap and a second lattice constant, wherein the second bandgap is less than the first bandgap and the second lattice constant is greater than the first lattice constant, and a lattice constant transition material positioned between the first subcell and the second subcell, the lattice constant transition material having a lattice constant that changes gradually from the first lattice constant to the second lattice constant.

In another aspect, the present invention provides a method of forming a multijunction solar cell comprising forming a first subcell comprising a first semiconductor material with a first band gap and a first lattice constant; forming a second subcell comprising a second semiconductor material with a second band gap and a second lattice constant, wherein the second band gap is less than the first band gap and the second lattice constant is greater than the first lattice constant; and forming a lattice constant transition material positioned between the first subcell and the second subcell, the lattice constant transition material having a lattice constant that changes gradually from the first lattice constant to the second lattice constant, wherein at least two of the subcells includes a heterojunction.

In another aspect, the present invention provides a method of forming a multijunction solar cell including forming a bottom a subcell having a band gap in the range of 0.8 to 1.2 eV; forming a middle subcell having a base and emitter, a bandgap in the range of 1.2 to 1.6 eV, and being disposed over and lattice mismatched to the bottom cell; and forming a top subcell having a base and emitter, having a band gap in the range of 1.8 to 2.1 eV, and being disposed over and lattice matched to the middle cell, wherein at least two of the base-emitter junctions in the middle and top subcells are heterojunctions.

In another aspect, the present invention provides a method of forming a multijunction solar cell comprising an upper subcell, a middle subcell, and a lower subcell, including: providing first substrate for the epitaxial growth of semiconductor material; forming a first solar subcell having a base and an emitter on the substrate having a first bandgap; forming a second solar subcell having a base and an emitter over the first solar subcell having a second bandgap smaller than the first band gap; forming a graded interlayer over the second subcell, the graded interlayer having a third band gap greater than the second band gap; and forming a third solar subcell having a base and an emitter over the graded interlayer having a fourth band gap smaller than the second band gap such that the third subcell is lattice mismatched with respect to the second subcell, wherein at least two of the subcells have heterojunction base-emitter layers.

A method of forming photovoltaic solar cell including forming a top cell including base and emitter layers of InGaP semiconductor material; forming a middle cell including a base layer of GaAs semiconductor material and a emitter layer of InGaP semiconductor material; and forming a bottom cell including an emitter layer composed of InGaP and base layer composed of an InGaAs semiconductor material.

In another aspect, the present invention provides a method of manufacturing a solar cell by providing a first substrate, depositing on the first substrate a sequence of layers of semiconductor material forming a solar cell, including at least two heterojunction subcells; mounting a surrogate substrate on top of the sequence of layers; and removing the first substrate.

BRIEF DESCRIPTION OF THE DRAWINGS

The invention will be better and more fully appreciated by reference to the following detailed description when considered in conjunction with the accompanying drawings, wherein:

FIG. 1 is a graph representing the bandgap of certain binary materials and their lattice constants;

FIG. 2 is a cross-sectional view of the solar cell of the invention after the deposition of semiconductor layers on the growth substrate;

FIG. 3 is a cross-sectional view of the solar cell of FIG. 2 after the next process step;

FIG. 4 is a cross-sectional view of the solar cell of FIG. 3 after next process step;

FIG. 5A is a cross-sectional view of the solar cell of FIG. 4 after the next process step in which a surrogate substrate is attached;

FIG. 5B is a cross-sectional view of the solar cell of FIG. 5A after the next process step in which the original substrate is removed;

FIG. 5C is another cross-sectional view of the solar cell of FIG. 5B with the surrogate substrate on the bottom of the Figure;

FIG. 6 is a simplified cross-sectional view of the solar cell of FIG. 5C after the next process step;

FIG. 7 is a cross-sectional view of the solar cell of FIG. 6 after the next process step;

FIG. 8 is a cross-sectional view of the solar cell of FIG. 7 after the next process step;

FIG. 9 is a cross-sectional view of the solar cell of FIG. 8 after the next process step;

FIG. 10A is a top plan view of a wafer in which the solar cells are fabricated;

FIG. 10B is a bottom plan view of a wafer in which the solar cells are fabricated;

FIG. 11 is a cross-sectional view of the solar cell of FIG. 9 after the next process step;

FIG. 12 is a cross-sectional view of the solar cell of FIG. 11 after the next process step;

FIG. 13 is a top plan view of the wafer of FIG. 12 after the next process step in which a trench is etched around the cell;

FIG. 14A is a cross-sectional view of the solar cell of FIG. 12 after the next process step in a first embodiment of the present invention;

FIG. 14B is a cross-sectional view of the solar cell of FIG. 14A after the next process step in a second embodiment of the present invention;

FIG. 15 is a cross-sectional view of the solar cell of FIG. 14B after the next process step in a third embodiment of the present invention; and

FIG 16 is a graph of the doping profile in a base layer in the metamorphic solar cell according to the present invention.

DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The basic concept of fabricating an inverted metamorphic multijunction (IMM) solar cell is to grow the subcells of the solar cell on a substrate in a "reverse" sequence. That is, the high bandgap subcells (i.e. subcells with bandgaps in the range of 1.8 to 2.1 eV), which would normally be the "top" subcells facing the solar radiation, are grown epitaxially on a semiconductor growth substrate, such as for example GaAs or Ge, and such subcells are therefore lattice-matched to such substrate. One or more lower bandgap middle subcells (i.e. with bandgaps in the range of 1.2 to 1.6 eV) can then be grown on the high bandgap subcells.

At least one lower subcell is formed over the middle subcell such that the at least one lower subcell is substantially lattice-mismatched with respect to the growth substrate and such that the at least one lower subcell has a third lower bandgap (i.e. a bandgap in the range of 0.8 to 1.2 eV). A surrogate substrate or support structure is provided over the "bottom" or substantially lattice-mismatched lower subcell, and the growth semiconductor substrate is subsequently removed. (The growth substrate may then subsequently be re-used for the growth of a second and subsequent solar cells).

The present application is generally directed to an inverted metamorphic multijunction solar cell, and its method of fabrication, that incorporates one or more heterojunctions. As noted in related U.S. Patent 7,071,407 of Fatemi et al., assigned to the co-assignee hereof, it is critical to have semiconductor materials having both lattice matching and optimal band gaps to enhance solar cell performance. In one embodiment of the present invention, a higher band gap heterojunction middle subcell is used to increase the photocurrent generated and the coverage of the solar spectrum.

Replacing a conventional homojunction middle subcell with a high band gap heterojunction middle subcell also has benefits in addition to increasing the light generated photocurrent. As noted in related U.S. Patent 7,071, 407 of Fatemi et al, a high band gap heterojunction decreases the dark saturated current, i.e. thermally generated charge carriers formed under zero illumination.

The open circuit voltage ($V_{oc}$) is determined the relationship:

$$V_{oc} = \frac{nkt}{q} In\left(\frac{j_{sc}}{J_{sat}}\right) + 1$$

where k is the Boltzman constant, T is the temperature, q is the electronic charge, $J_{sc}$ is the short circuit current density, n is the diode ideality factor, and $J_{sat}$ is the saturation current density of the diode. In other words, using a high band gap heterojunction middle subcell reduces dark saturated current and consequently, provides a larger open circuit voltage ($V_{oc}$).

A triple-junction solar cell structure having a high band gap heterojunction middle subcell provides higher open circuit voltage and higher short circuit current. In other words, the sunlight or photogenerated photocurrent increases by utilizing a higher band gap emitter heterojunction, since the amount of photons that can be absorbed in the emitter region is relatively low compared to the absorption in the base region. Thus, another advantage of using a heterojunction middle subcell is that the emitter with high band gap semiconductor material is more efficient to pass the sub-band-gap sunlight to the base region. Accordingly, a high band gap heterojunction middle subcell provides a larger short circuit current since it offers higher average collection probability of photogenerated carriers.

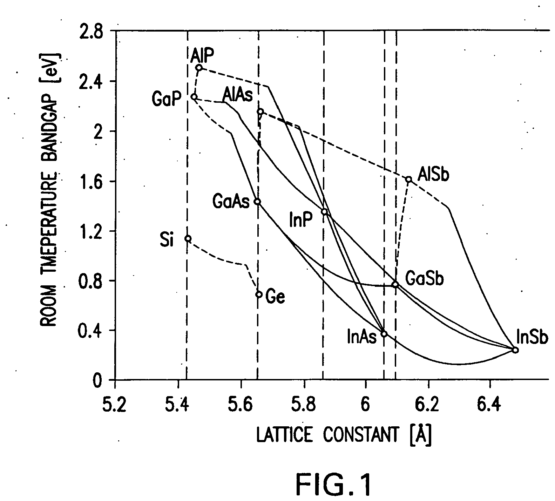

By way of background, FIG. 1 is a graph representing the bandgap of certain binary materials and their lattice constants. The bandgap and lattice constants of ternary materials are located on the solid lines drawn between typical associated binary materials (such as GaA1 As being between the GaAs and AlAs points on the graph, with the bandgap varying between 1.42 eV for GaAs and 2.16 eV for AlAs). Thus, depending upon the desired bandgap, the material constituents of a ternary material can be appropriately selected for growth.

The lattice constants and electrical properties of the layers in the semiconductor structure are preferably controlled by specification of appropriate reactor growth temperatures and times, and by use of appropriate composition and dopants. The use of a vapor deposition method, such as Organo Metallic Fapor Phase Epitaxy (OMVPE), Metal Organic Chemical Vapor Deposition (MOCVD), Molecular Beam Epitaxy (MBE), or other vapor deposition methods for the reverse growth may enable the layers in the monolithic semiconductor structure forming the cell to be grown with the required thickness, elemental composition, dopant concentration and grading and conductivity type.

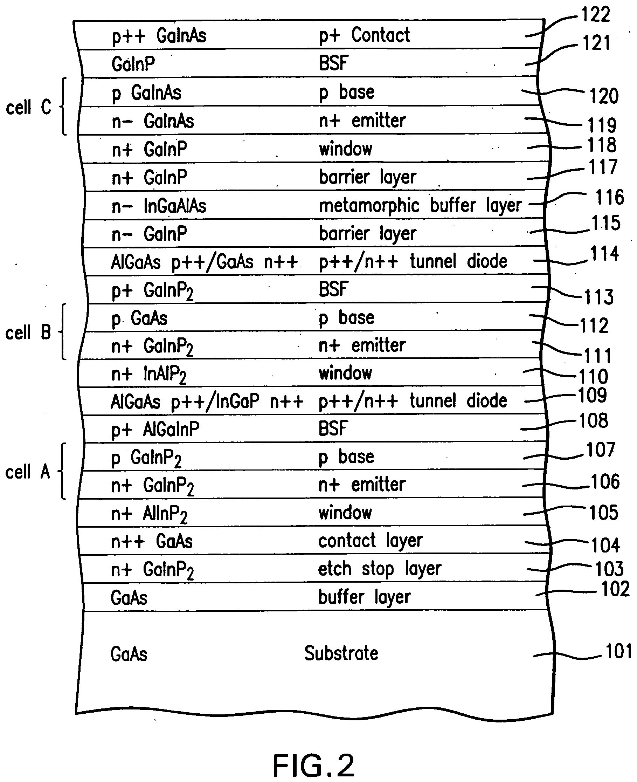

FIG. 2 depicts the inverted metamorphic multijunction (IMM) solar cell structure according to the present invention after epitaxial growth of the three subcells A, B and C on a substrate. Earlier embodiments of IMM solar cell structure described in the related patent applications noted above incorporated homo-junction subcells, i.e. base/emitter layers consisting of a p-InGaP/n-InGaP top cell, a n-GaAs/p-GaAs middle cell, and an n-InGaAs/p-InGaAs bottom cell. The analysis of internal quantum efficiency and $V_{oc}$ data measurements made on such solar cells indicate that such subcells can benefit from an improvement in blue response and reduction in dark current.

Degradation in the blue response of a solar cell is associated with recombination current in the emitter and at the window/emitter interface. If the emitter bandgaps of the subcells below the top subcell, that is, the middle and bottom subcell emitter bandgaps, are greater than or equal to the top cell bandgap, then no radiation will be present to be absorbed in the emitters. All radiation impinging on the lower bandgap subcells will be absorbed in the lower doped, better-collecting base regions, thereby, maximizing the blue responses. In addition, recombination currents generated by optical absorption will be absent from the lower subcell emitters and emitter/window regions. Granted, the improvements in current collection and increased $V_{oc}$ values may be small but they are significant in optimizing cell performance.

The problem is to maximize the short circuit current density ($J_{sc}$) and open circuit voltage ($V_{oc}$) from each subcell. Optically generated recombination currents in the emitter and at the window/emitter interface negatively impact both $J_{sc}$ and $V_{oc}$. This problem is often addressed by (1) growing a very low defect window/emitter interface with large valance bandgap off-set, and (2) incorporating a drift field in the emitter to drive the minority carriers to the junction. The present invention eliminates the optical properties of the window/emitter interface and emitter from the subcell performance, since substantially all optically generated minority carriers are created in the base regions.

Turning to the solar cell structure depicted in FIG. 2, there is shown a substrate 101, which may be either gallium arsenide (GaAs), germanium (Ge), or other suitable material. In the case of a Ge substrate, a nucleation layer (not shown) is deposited directly on the substrate. On the substrate, or over the nucleation layer (in the case of a Ge substrate), a buffer layer 102 and an etch stop layer 103 are further deposited. In the case of GaAs substrate, the buffer layer 102 is preferably GaAs.

In the case of Ge substrate, the buffer layer 102 is preferably InGaAs. A contact layer 104 of GaAs is then deposited on layer 103, and a window layer 105 of A1InP is deposited on the contact layer. The subcell A, consisting of an n+ emitter layer 106 and a p-type base layer 107, is then epitaxially deposited on the window layer 105. The subcell A is generally latticed matched to the growth substrate 101.

It should be noted that the multijunction solar cell structure could be formed by any suitable combination of group III to V elements listed in the periodic table subject to lattice constant and bandgap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

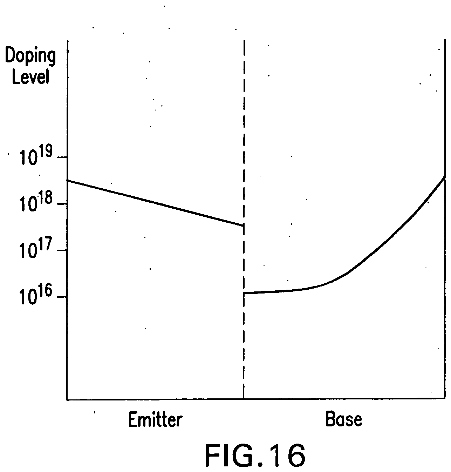

In the preferred embodiment, the emitter layer 106 is composed of InGa(Al)P and the base layer 107 is composed of InGa(Al)P. The aluminum or Al term in parenthesis in the preceding formula means that Al is an optional constituent, and in this instance may be used in an amount ranging from 0% to 30%. The doping profile of the emitter and base layers 106 and 107 according to the present invention will be discussed in conjunction with FIG. 16.

Subcell A will ultimately become the "top" subcell of the inverted metamorphic structure after completion of the process steps according to the present invention to be described hereinafter.

On top of the base layer 178 a back surface field ("BSF") layer 108 is deposited and used to reduce recombination loss, preferably p+ AlGaInP.

The BSF layer 108 drives minority carriers from the region near the base/BSF interface surface to minimize the effect of recombination loss. In other words, a BSF layer 18 reduces recombination loss at the backside of the solar subcell A and thereby reduces the recombination in the base.

On top of the BSF layer 108 is deposited a sequence of heavily doped p-type and n-type layers 109 which forms a tunnel diode which is a circuit element to connect subcell A to subcell B. These layers are preferably composed of p++ AlGaAs, and n++ InGaP.

On top of the tunnel diode layers 109 a window layer 110 is deposited, preferably n+ InAlP. The window layer 110 used in the subcell B also operates to reduce the recombination loss. The window layer 110 also improves the passivation of the cell surface of the underlying junctions. It should be apparent to one skilled in the art, that additional layer(s) may be added or deleted in the cell structure without departing from the scope of the present invention.

On top of the window layer 110 the layers of subcell B are deposited: the n-type emitter layer 111 and the p-type base layer 112. These layers are composed of InGaP and $In_{0.015}GaAs$ respectively (for a Ge substrate or growth template), or InGaP and GaAs respectively (for a GaAs substrate), although any other suitable materials consistent with lattice constant and bandgap requirements may be used as well. Thus, subcell B may be composed of a GaAs, GaInP, GaInAs, GaAsSb, or GaInAsN emitter region and a GaAs, GaInAs, GaAsSb, or GaInAsN base region. The doping profile of layers 111 and 112 according to the present invention will be discussed in conjunction with FIG. 16.

In the preferred embodiment of the present invention, the middle subcell emitter has a band gap equal to the top subcell emitter, and the bottom subcell emitter has a band gap greater than the band gap of the base of the middle subcell. Therefore, after fabrication of the solar cell, and implementation and operation, neither the middle subcell B nor the bottom subcell C emitters will be exposed to absorbable radiation. Substantially radiation will be absorbed in the bases of cells B and C, which have narrower band gaps then the emitters. Therefore, the advantages of using heterojunction subcells are: 1) the short wavelength response for both subcells will improve, and 2) the recombination currents at the emitter/window interface and in the emitter will decrease. These results will increase $J_{sc}$ and $V_{oc}$.

On top of the cell B is deposited a BSF layer 113 which performs the same function as the BSF layer 109. A p++/n++ tunnel diode 114 is deposited over the BSF layer 113 similar to the layers 109, again forming a circuit element to connect subcell B to subcell C. These layers 114 are preferably compound of p++ AlGaAs and n++ InGaP.

A barrier layer 115, preferably composed of n-type InGa(Al)P, is deposited over the tunnel diode 114, to a thickness of about 1.0 micron. Such barrier layer is intended to prevent threading dislocations from propagating, either opposite to the direction of growth into the middle and top subcells B and C, or in the direction of growth into the bottom subcell A, and is more particularly described in U.S. Patent Application Publication US 2009/0078309 A1, filed September 24, 2007.

A metamorphic layer (or graded interlayer) 116 is deposited over the barrier layer 115. Layer 116 is a compositionally step-graded series of InGaAlAs layers, preferably with monotonically changing lattice constant, so as to achieve a gradual transition in lattice constant in the semiconductor structure from subcell B to subcell C while minimizing threading dislocations from occurring. The bandgap of layer 116 is constant throughout its thickness preferably approximately 1.5 eV or otherwise consistent with a value slightly greater than the bandgap of the middle subcell B. The preferred embodiment of the graded interlayer may also be expressed as being composed of $(In_xGa_{1-x})_yAl_{1-y}As$, with x and y selected such that the band gap of the interlayer remains constant at approximately 1.50 eV.

In an alternative example (not a part of the invention) where the solar cell has only two subcells, and the "middle" cell B is the uppermost or top subcell in the final solar cell, wherein the "top" subcell B would typically have a bandgap of 1.8 to 1.9 eV, then the band gap of the interlayer would remain constant at 1.9 eV.

In the inverted metamorphic structure described in the Wanless et al. paper cited above, the metamorphic layer consists of nine compositionally graded InGaP steps, with each step layer having a thickness of 0.25 micron. As a result, each layer of Wanless has a different bandgap. In the preferred embodiment of the present invention, the layer 116 is composed of a plurality of layers of InGaAlAs, with monotonically changing lattice constant, each layer having the same bandgap, approximately 1.5 eV.

The advantage of utilizing a constant bandgap material such as InGaAlAs is that arsenide-based semiconductor material is much easier to process in standard MOCVD reactors, while the small amount of aluminum assures radiation transparency of the metamorphic layers.

Although the present invention utilizes a plurality of layers of InGaAlAs for the metamorphic layer 116 for reasons of manufacturability and radiation transparency, other examples may utilize different material systems to achieve a change in lattice constant from subcell B to subcell C. Thus, the system of Wanlass using compositionally graded InGaP is another example (not forming a part of the invention). Other embodiments of the present invention may utilize continuously graded, as opposed to step graded, materials. More generally, the graded interlayer may be composed of any of the As, P, N, Sb based III - V compound semiconductors subject to the constraints of having the in-plane lattice parameter greater or equal to that of the second solar cell and less than or equal to that of the third solar cell, and having a bandgap energy greater than that of the second solar cell.

In another embodiment of the present invention, an optional second barrier layer 117 may be deposited over the InGaAlAs metamorphic layer 116. The second barrier layer 117 will typically have a different composition than that of barrier layer 115, and performs essentially the same function of preventing threading dislocations from propagating. In the preferred embodiment, barrier layer 117 is n+ type GaInP.

A window layer 118 preferably composed of n+ type GaInP is then deposited over the barrier layer 117 (or directly over layer 116, in the absence of a second barrier layer). This window layer operates to reduce the recombination loss in subcell "C". It should be apparent to one skilled in the art that additional layers may be added or deleted in the cell structure without departing from the scope of the present invention.

On top of the window layer 118, the layers of cell C are deposited: the n- emitter layer 119, and the p-type base layer 120. These layers are preferably composed of n type InGaP and p type InGaAs for a heterojunction subcell, although another suitable materials consistent with lattice constant and bandgap requirements may be used as well. The doping profile of layers 119 and 120 will be discussed in connection with FIG. 16.

A BSF layer 121, preferably composed of GaIn-AsP, is then deposited on top of the cell C, the BSF layer performing the same function as the BSF layers 108 and 113.

Finally a p++ contact layer 122 composed of GaInAs is deposited on the BSF layer 121.

It should be apparent to one skilled in the art, that additional layer(s) may be added or deleted in the cell structure without departing from the scope of the present invention.

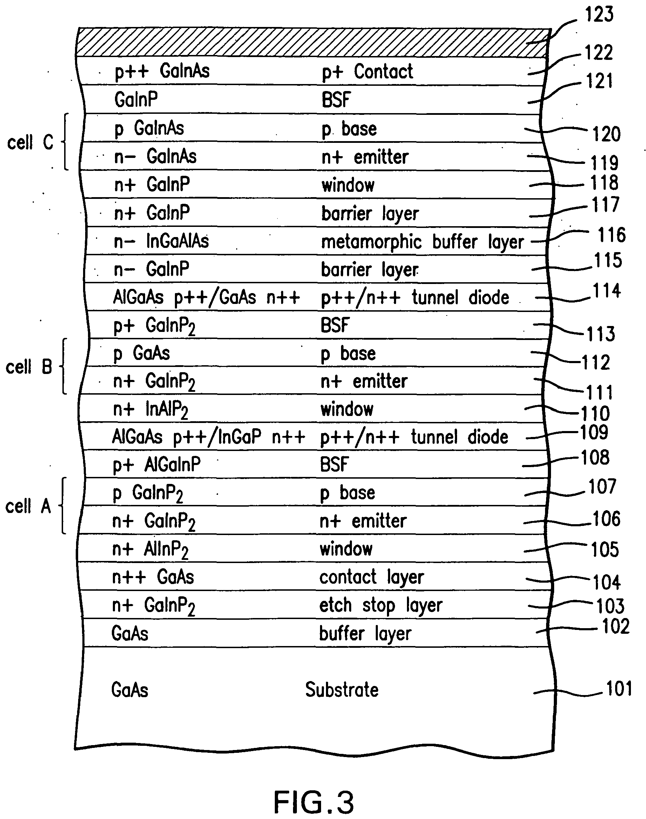

FIG. 3 is a cross-sectional view of the solar cell of FIG. 2 after the next process step in which a metal contact layer 123 is deposited over the p+ semiconductor contact layer 122. The metal is preferably the sequence of metal layers Ti/Au/Ag/Au.

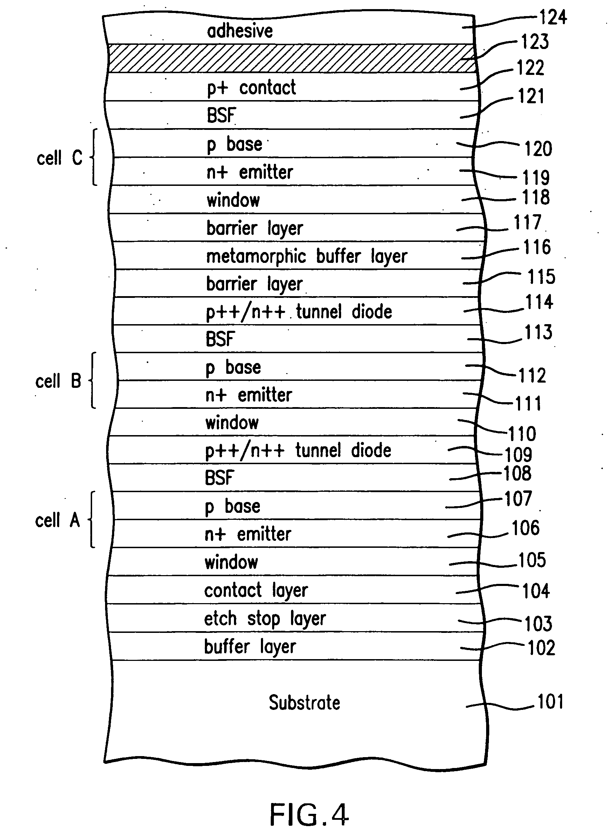

FIG. 4 is a cross-sectional view of the solar cell of FIG. 3 after the next process step in which an adhesive layer 124 is deposited over the metal layer 123. The adhesive is preferably Wafer Bond (manufactured by Brewer Science, Inc. of Rolla, MO.).

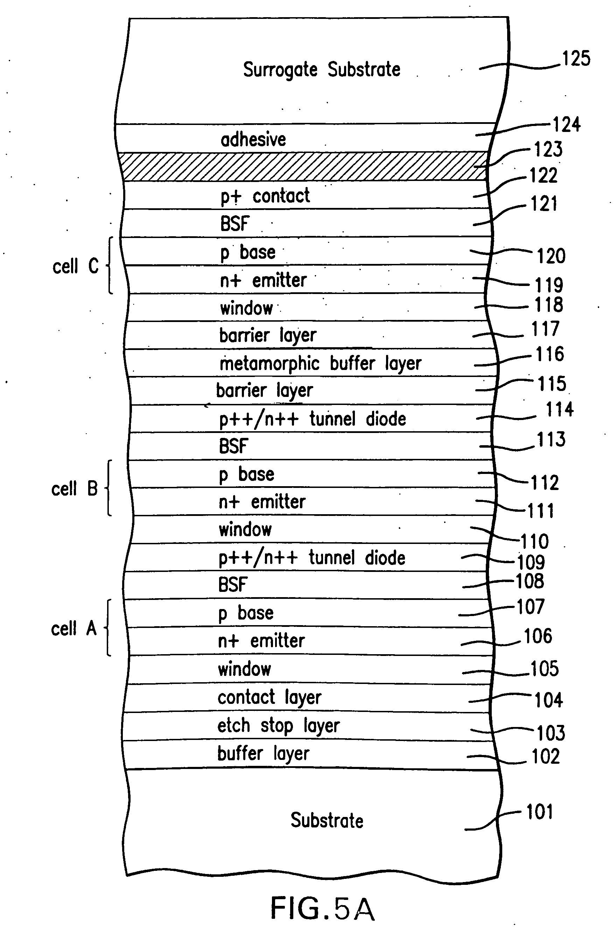

FIG. 5A is a cross-sectional view of the solar cell of FIG. 4 after the next process step in which a surrogate substrate 125, preferably sapphire, is attached. Alternatively, the surrogate substrate may be GaAs, Ge or Si, or other suitable material. The surrogate substrate is about 40 mils (1.016 mm) in thickness, and is perforated with holes about 1 mm in diameter, spaced 4 mm apart, to aid in subsequent removal of the adhesive and the substrate. As an alternative to using an adhesive layer 124, a suitable substrate (e.g., GaAs) may be eutectically bonded to the metal layer 123.

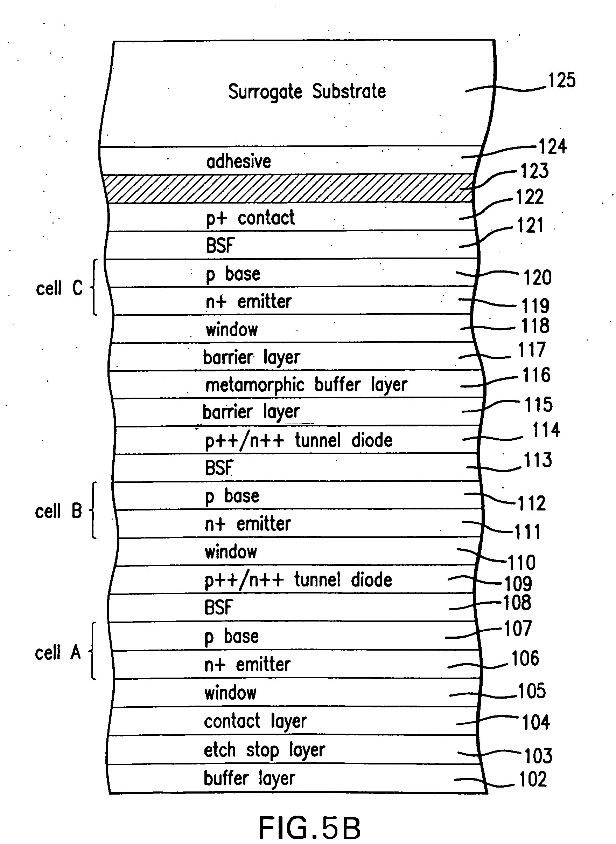

FIG. 5B is a cross-sectional view of the solar cell of FIG. 5A after the next process step in which the original substrate is removed by a sequence of lapping and/or etching steps in which the substrate 101, the buffer layer 103, and the etch stop layer 103, are removed. The choice of a particular etchant is growth substrate dependent.

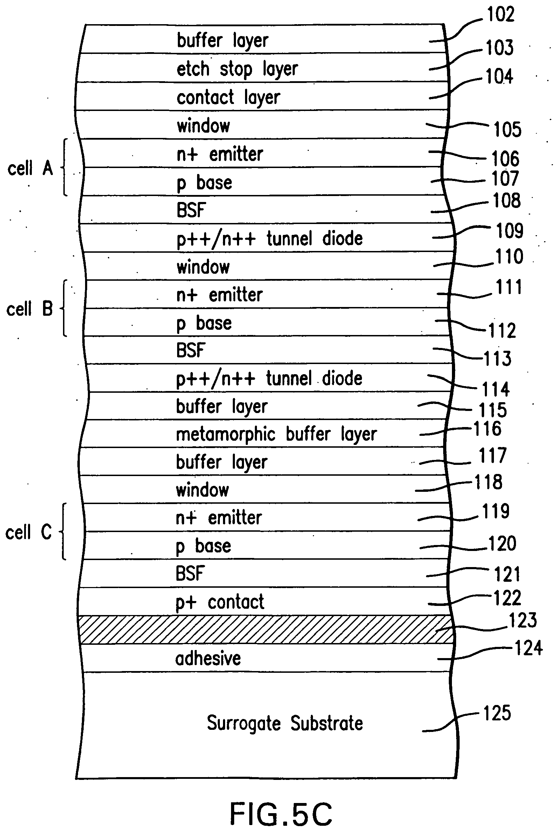

FIG. 5C is a cross-sectional view of the solar cell of FIG. 5B with the orientation with the surrogate substrate 125 being at the bottom of the Figure. Subsequent Figures in this application will assume such orientation.

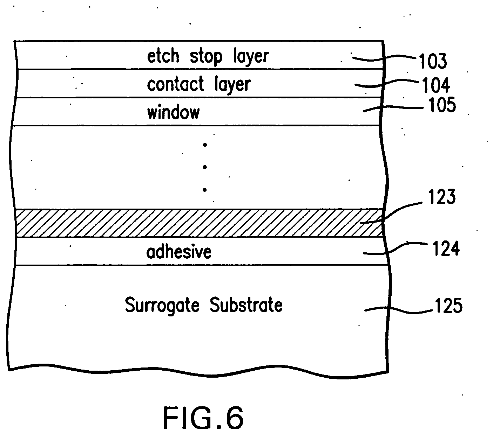

FIG. 6 is a simplified cross-sectional view of the solar cell of FIG. 5B depicting just a few of the top layers and lower layers over the surrogate substrate 125.

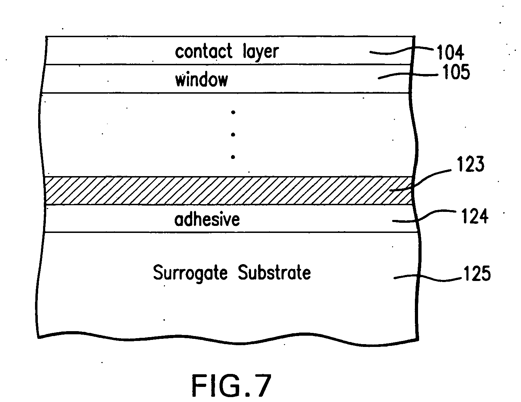

FIG. 7 is a cross-sectional view of the solar cell of FIG. 6 after the next process step in which the etch stop layer 103 is removed by a HCl/$H_2$O solution.

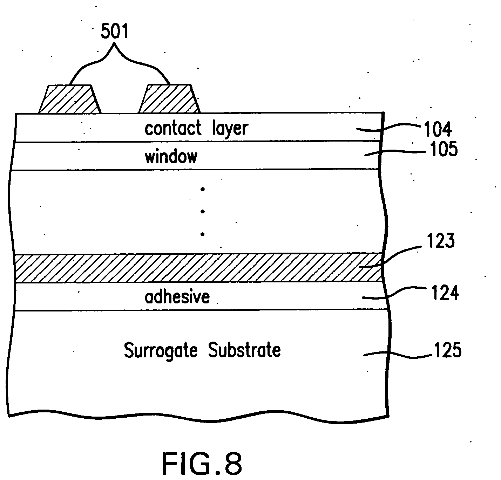

FIG. 8 is a cross-sectional view of the solar cell of FIG. 7 after the next sequence of process steps in which a photoresist mask (not shown) is placed over the contact layer 104 to form the grid lines 501. The grid lines 501 are deposited via evaporation and lithographically patterned and deposited over the contact layer 104. The mask is lifted off to form the metal grid lines 501.

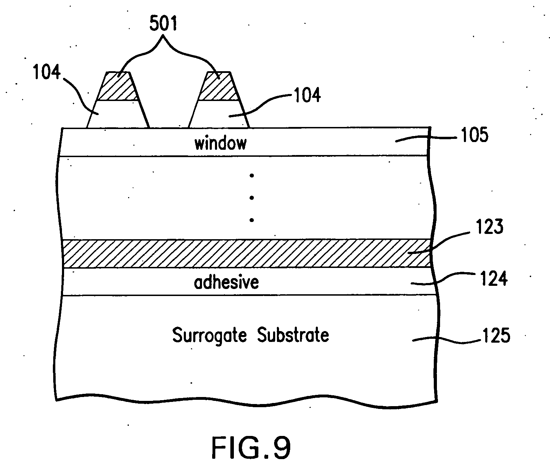

FIG. 9 is a cross-sectional view of the solar cell of FIG. 8 after the next process step in which the grid lines are used as a mask to etch down the surface to the window layer 105 using a citric acid/peroxide etching mixture,

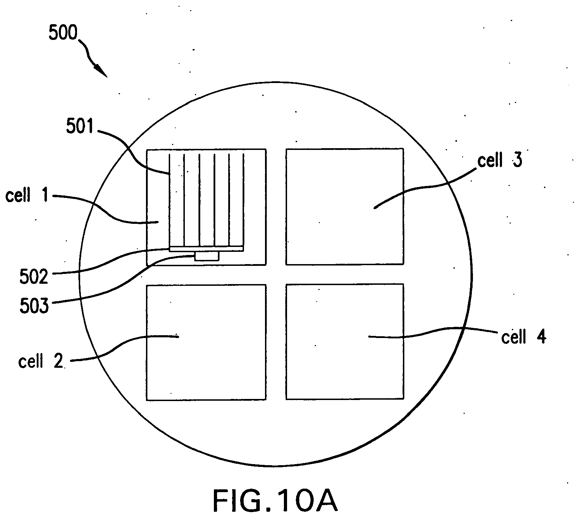

FIG. 10A is a top plan view of a wafer in which for solar cells are implemented. The depiction of four cells is for illustration for purposes only, and the present invention is not limited to any specific number of cells per wafer.

In each cell there are grid lines 501 (more particularly shown in cross-section in FIG. 9), an interconnecting bus line 502, and a contact pad 503. The geometry and number of grid and bus lines is illustrative and the present invention is not limited to the illustrated embodiment.

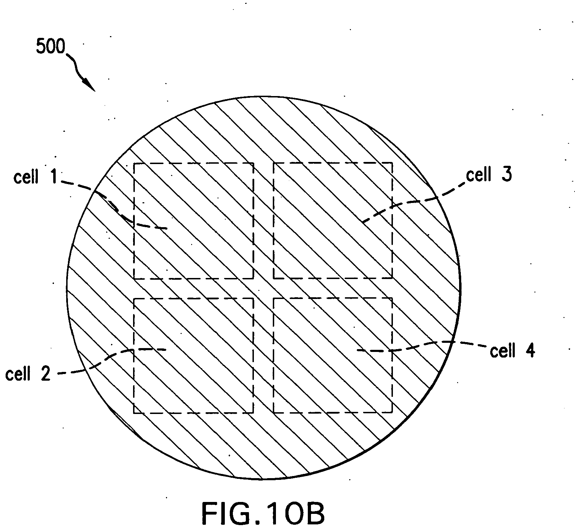

FIG. 10B is a bottom plan view of the wafer with four solar cells shown in FIG. 10A.

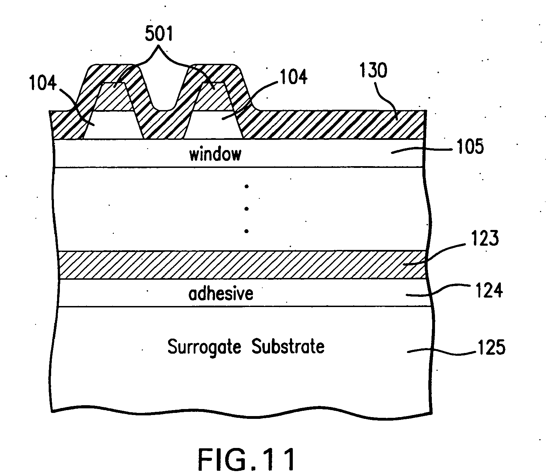

FIG. 11 is a cross-sectional view of the solar cell of FIG. 11 after the next process step in which an antireflective (ARC) dielectric coating layer 130 is applied over the entire surface of the "bottom" side of the wafer with the grid lines 501.

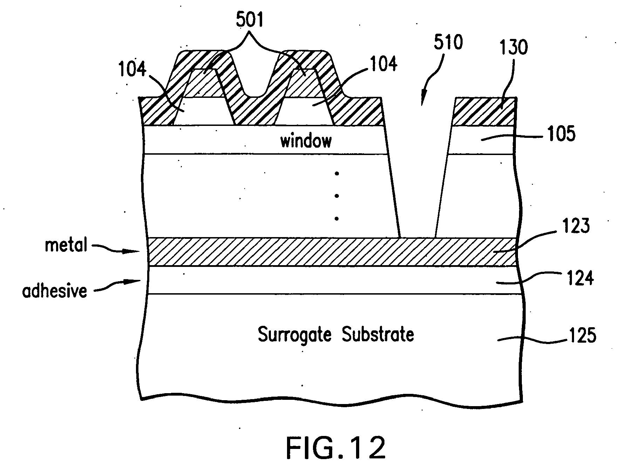

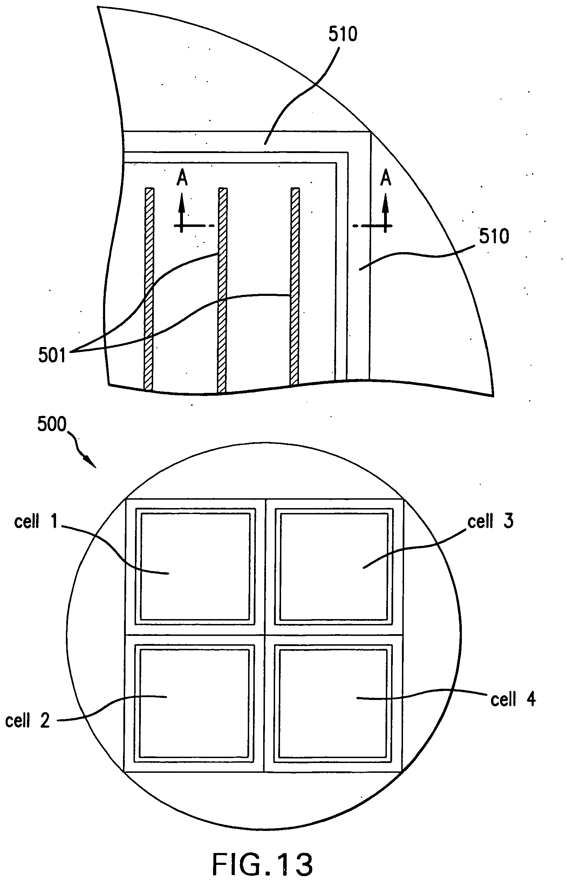

FIG. 12 is a cross-sectional view of the solar cell of FIG. 11 after the next process step according to the present invention in which a channel 510 or portion of the semiconductor structure is etched down to the metal layer 123 using phosphide and arsenide etchants defining a peripheral boundary and leaving a mesa structure which constitutes the solar cell. The cross-section depicted in FIG 12 is that as seen from the A-A plane shown in FIG. 13.

FIG 13 is a top plan view of the wafer of FIG. 12 depicting the channel 510 etched around the periphery of each cell using phosphide and arsenide etchants.

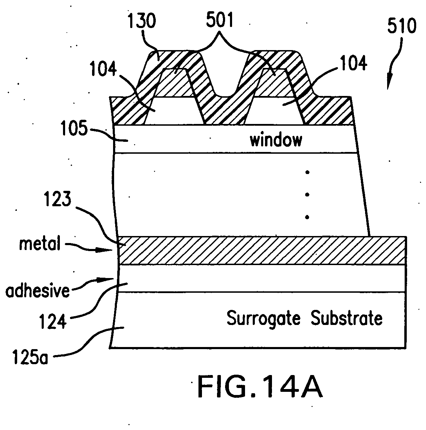

FIG. 14A is a cross-sectional view of the solar cell of FIG. 12 after the next process step in a first embodiment of the present invention in which the surrogate substrate 125 is appropriately thinned to a relatively thin layer 125a, by grinding, lapping, or etching.

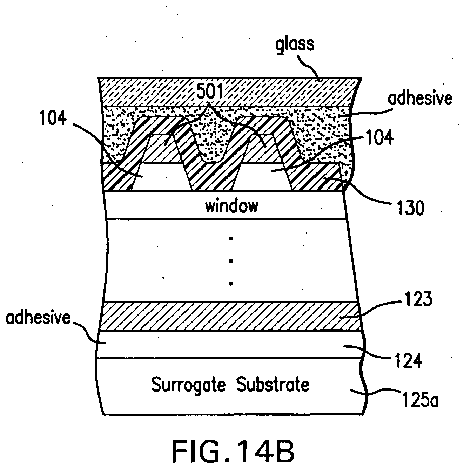

FIG. 14B is a cross-sectional view of the solar cell of FIG. 14A after the next process step in a second embodiment of the present invention in which a cover glass is secured to the top of the cell by an adhesive.

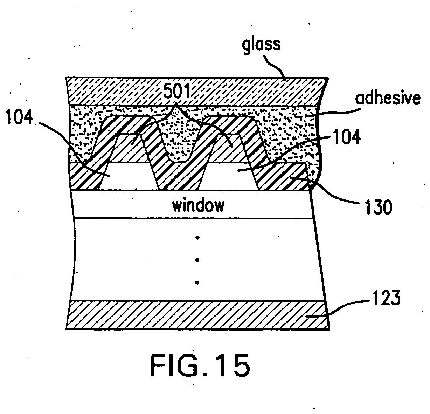

FIG. 15 is a cross-sectional view of the solar cell of FIG. 14B after the next process step in a third embodiment of the present invention in which a cover glass is secured to the top of the cell and the surrogate substrate 125 is entirely removed, leaving only the metal contact layer 123 which forms the backside contact of the solar cell. The surrogate substrate may be reused in subsequent wafer processing operations.

FIG. 16 is a graph of a doping profile in the emitter and base layers in one or more subcells of the inverted metamorphic multijunction solar cell of the present invention. The various doping profiles within the scope of the present invention, and the advantages of such doping profiles are more particularly described in U.S. Patent Application Publication US 2009/0155952 A1 filed December 13, 2007. The doping profiles depicted herein are merely illustrative, and other more complex profiles may be utilized as would be apparent to those skilled in the art without departing from the scope of the present invention.

It will be understood that each of the elements described above, or two or more together, also may find a useful application in other types of constructions differing from the types of constructions described above.

Although the preferred embodiment of the present invention utilizes a vertical stack of three subcells, the present invention can apply to stacks with fewer or greater number of subcells, i.e. two junction cells, four junction cells, five junction cells, etc. In the case of four or more junction cells, the use of more than one metamorphic grading interlayer may also be utilized.

The structures and methods according to the present invention can be applied to form cells with either p/n or n/p configurations, or both, with suitable choice of the conductivity type of the growth substrate. If the growth substrate has the opposite conductivity type from that needed for the configuration of the p and n layer sequence in the cell, appropriate tunnel diodes can be used throughout the cells as illustrated in the present invention.

In addition, although the preferred embodiment is configured with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals such that most of the available photogenerated current density in each subcell can be used effectively, leading to high efficiency for the multijunction cell, notwithstanding that the photogenerated current densities are typically different in the various subcells.

As noted above, the present invention may utilize an arrangement of one or more homojunction cells or subcells, i.e. a cell or subcell in which the p-n junction is formed between a p-type semiconductor and an n-type semiconductor both of which have the same chemical composition and the same band gap, differing only in the dopant species and types, and one or more heterojunction cells or subcells. Subcell A, with p-type and n-type InGaP is one example of a homojunction subcell. The present invention utilizes one or more, or all, heterojunction cells or subcells, i.e., a cell or subcell in which the p-n junction is formed between a p-type semiconductor and an n-type semiconductor having different chemical compositions of the semiconductor material in the n-type and n-type regions, and/or different band gap energies in the p-type regions, in addition to utilizing different dopant species and type in the p-type and n-type regions that form the pn-junction.

In some cells, a thin so-called "intrinsic layer" may be placed between the emitter layer and base layer, with the same or different composition from either the emitter base layer. The intrinsic layer functions to suppress minority-carrier recombination in the space-charge region. Similarly, either the base layer or, the emitter layer may also be intrinsic or not-intentionally-doped ("ND") over part or all of its thickness.

The composition of the window or BSF layers may utilize other semiconductor compounds, subject to lattice constant and band gap requirements, and may include AlInP, AlAs, AlP, AlGaInP, AlGaAsP, AlGaInAs, A1GaInPAs, GaInP, GaInAs, GaInPAs, AlGaAs, Al InAs, AlInPAs, GaAsSb, AlAsSb, GaAlAsSb, AlInSb, GaInSb, AlGaInSb, AlN, GaN, InN, GaInN, AlGaInN, GaInNAs, AlGaInNAs, ZnSSe, CdSSe, and similar materials.

While the invention has been illustrated and described as embodied in a inverted metamorphic multijunction solar cell, it is not intended to be limited to the details shown, since various modifications and structural changes may be made without departing in any way from the scope of the present invention.

Thus, while the description of this invention has focused primarily on solar cells or photovoltaic devices, persons skilled in the art know that other optoelectronic devices, such as thermophotovoltaic (TPV) cells, photodetectors and light-emitting diodes (LEDs) are very similar in structure, physics, and materials to photovoltaic devices with only some minor variations in doping and the like: For example, photodetectors can be fabricated from similar III-V materials and structures as the photovoltaic devices described above, but perhaps more lightly-doped regions for light sensitivity rather than maximizing power production. Similarly, LEDs can also be made with similar structures and materials, but perhaps more heavily-doped regions to shorten recombination time, thus radiative lifetime to produce light instead of power. Therefore, this invention also applies to photodetectors and LEDs with similar structures, materials, and compositions of matter, the related articles of manufacture and improvements as described above for photovoltaic cells.

Without further analysis, the foregoing will so fully reveal the gist of the present invention that others can, by applying current knowledge, readily adapt it for various applications without omitting features that, from the standpoint of prior art, fairly constitute essential characteristics of the generic or specific aspect of this invention and, therefore, such adaptations should and are intended to be comprehended within the meaning and range of equivalence of the claims.

**Claims**

1. A multijunction solar cell comprising:

   an upper first solar sub-cell (A) comprising an emitter (106) and a base (107) both having a first bandgap, and being composed of InGa(Al)P.
   a middle second solar sub-cell (B) adjacent to said upper first solar sub-cell (A) and having a heterojunction InGaP emitter (111) and a GaAs or $In_{0.015}$GaAs base (112), having a band gap in the range of 1.2 to 1.6 eV, the emitter of the middle solar sub-cell (B) having also a first bandgap equal to the first bandgap of the emitter of the upper first sub-cell, and

wherein the base (112) of the middle second subcell (B) has a second bandgap that is narrower than the first bandgap of the emitter (111) of the middle subcell (B) such that said middle subcell (B) is lattice matched with respect to said upper subcell (A),

a graded interlayer (116) adjacent to said middle solar subcell (B), said graded interlayer (116) having a third bandgap greater than the second bandgap of the base of said middle subcell (B); and wherein the graded interlayer is composed of $(In)(Ga_{1-x})_y Al_{1-y}As$ and has a constant bandgap, wherein the upper subcell is disposed over and being lattice matched to the middle subcell, and has a band gap in the range of 1.8 to 2.1 eV; and

a lower third solar subcell (C) adjacent to said graded interlayer having a heterojunction emitter (119) and base (120), the emitter of the lower subcell (C) having a fourth bandgap greater than the second bandgap of the base of the middle subcell (B), wherein said lower solar subcell being composed of an InGaAs base and an InGaP emitter lattice matched to the base,

wherein the base of the lower subcell has a bandgap in the range of 0.8 to 1.2 eV,

the base of the middle subcell has a band gap in the range of 1.2 to 1.6 eV, and the upper subcell is disposed over and being lattice matched to the middle subcell, and has a band gap in the range of 1.8 to 2.1 eV.

wherein the fifth bandgap of the base of the lower subcell (C) is

a) narrower than the fourth bandgap of the emitter of the lower subcell (C), and
b) narrower than the second bandgap of the base of the middle subcell (B) such that said lower subcell (C) is lattice mismatched with respect to said middle subcell (B).

2. The multijunction solar cell of claim 1, wherein the graded interlayer (116) is compositionally graded to lattice match the middle subcell (B) on one side and the lower subcell (C) on the other side.

3. The multijunction solar cell as defined in claim 1, wherein said graded interlayer (116) is composed of any of the As, P, N, Sb based III - V compound semiconductors subject to the constraints of having the in-plane lattice parameter greater or equal to that of the middle subcell (B) and less than or equal to that of the lower subcell (C), and having a bandgap energy greater than that of the bandgap of the base (112) of the middle subcell (B).

4. The multijunction solar cell as defined in one ore more of the preceding claims, wherein said lower subcell (C) is disposed over a substrate (125) selected from the group of sapphire, GaAs, Ge or Si, and is bonded to said substrate by an adhesive (124).

5. A method of manufacturing a multijunction solar cell as defined in claim 1, comprising:

providing a first substrate (101);
depositing on a first substrate (101) a sequence of layers of semiconductor material forming a solar cell including at least one base-emitter junction forming a heterojunctions;
mounting a surrogate substrate (125) on top of the sequence of layers; and
removing the first substrate (101).

6. A method as defined in claim 5, wherein a transition material is composed of any of the As, P, N, Sb based III - V compound semiconductors subject to the constraints of having the in-plane lattice parameter greater or equal to that of the upper subcell (A) and less than or equal to that of the middle subcell (B), and having a band gap energy greater than that of the base (112) of the middle subcell (B), and the band gap of the interlayer (116) remains constant at approximately 1.50 eV.

7. A method as defined in claim 5, wherein said middle subcell (B) is composed of an GaInP, GaAs, GaInAs, GaAsSb, or GaInAsN emitter region (111) and an GaAs, GaInAs, GaAsSb, or GaInAsN base region (112).

**Patentansprüche**

1. Mehrfachsolarzelle, umfassend:

eine obere erste Solar-Subzelle (A), umfassend einen Emitter (106) und eine Basis (107), wobei beide eine erste Bandlücke aufweisen und aus InGa(Al)P zusammengesetzt sind, eine mittlere zweite Solar-Subzelle (B), die an die erste Solar-Subzelle (A) angrenzt und einen Heterojunction-InGaP-Emitter (111) und eine GaAs oder $In_{0.015}$GaAs-Basis (112) aufweist und eine Bandlücke in dem Bereich von 1,2 bis 1,6 eV aufweist, wobei der Emitter der mittleren Solar-Subzelle (B) ebenfalls eine erste Bandlücke aufweist, die gleich zu der ersten Bandlücke des Emitters der oberen ersten Subzelle ist, und wobei die Basis (112) der mittleren zweiten Subzelle (B) eine zweite Bandlücke aufweist, die schmaler ist als die erste Bandlücke des Emitters (111) der mittleren Subzelle (B), sodass die mittlere Subzelle (B) in Bezug auf die obere Subzelle (A) gitterangepasst ist,
eine abgestufte Zwischenschicht (116), die an die mittlere Solar-Subzelle (B) angrenzt, wobei die abgestufte Zwischenschicht (116) eine dritte Bandlücke aufweist, die größer ist als die zweite Bandlücke der Basis der mittleren Subzelle (B); und wobei die abgestufte Zwischenschicht aus $(In_xGa_{1-x})_yAl_{1-y}As$ zusammengesetzt ist und eine konstante Bandlücke aufweist, wobei die obere Subzelle auf der mittleren Subzelle angeordnet ist und zu ihr gitterangepasst ist und eine Bandlücke in dem Bereich von 1,8 bis 2,1 eV aufweist; und
eine untere dritte Solar-Subzelle (C), die an die abgestufte Zwischenschicht angrenzt, die einen Heterojunction-Emitter (119) und eine Basis (120) aufweist, wobei der Emitter der unteren Subzelle (C) eine vierte Bandlücke aufweist, die größer als die zweite Bandlücke der Basis der mittleren Subzelle (B) ist, wobei die untere Solar-Subzelle aus einer InGaAs-Basis und einem InGaP-Emitter zusammengesetzt ist, der an die Basis gitterangepasst ist,

wobei die Basis der unteren Subzelle eine Bandlücke in dem Bereich von 0,8 bis 1,2 eV aufweist,

die Basis der mittleren Subzelle eine Bandlücke in dem Bereich von 1,2 bis 1,6 eV aufweist, und die obere Subzelle auf der mittleren Subzelle angeordnet ist und an sie gitterangepasst ist und eine Bandlücke in dem Bereich von 1,8 bis 2,1 eV aufweist,
wobei die fünfte Bandlücke der Basis der unteren Subzelle (C)

a) schmaler als die vierte Bandlücke des Emitters der unteren Subzelle (C) ist, und
b) schmaler als die zweite Bandlücke der Basis der mittleren Subzelle (B) ist, so dass die untere Subzelle (C) in Bezug auf die mittlere Subzelle (B) eine Gitterfehlanpassung aufweist.

2. Mehrfachsolarzelle nach Anspruch 1, wobei die abgestufte Zwischenschicht (116) kompositionell abgestuft ist, um an die mittlere Subzelle (B) auf der einen Seite und die untere Subzelle (C) auf der anderen Seite gitterangepasst zu sein.

3. Mehrfachsolarzelle nach Anspruch 1, wobei die abgestufte Zwischenschicht (116) aus irgendeinem der III-V-Verbindungshalbleiter auf der Basis von As, P, N, Sb zusammengesetzt ist, die den Beschränkungen unterliegen, dass der Gitterparameter in der Ebene größer oder gleich dem der mittleren Subzelle (B) und kleiner oder gleich dem der unteren Subzelle (C) ist und eine Bandlückenenergie aufweist, die größer als die der Bandlücke der Basis (112) der mittleren Subzelle (B) ist.

4. Mehrfachsolarzelle nach einem oder mehreren der vorhergehenden Ansprüche, wobei die untere Subzelle (C) auf einem Substrat (125) angeordnet ist, das aus der Gruppe aus Saphir, GaAs, Ge oder Si ausgewählt ist, und mit dem Substrat durch einen Klebstoff (124) verbunden ist.

5. Verfahren zum Herstellen einer Mehrfachsolarzelle nach Anspruch 1, umfassend:

Bereitstellen eines ersten Substrats (101);
Abscheiden einer Folge von Schichten aus Halbleitermaterial auf einem ersten Substrat (101), die eine Solarzelle bilden, die mindestens einen Basis-Emitter-Übergang enthält, der einen Heteroübergang bildet;
Anbringen eines Ersatzsubstrats (125) auf der Folge von Schichten; und
Entfernen des ersten Substrats (101).

6. Verfahren nach Anspruch 5, wobei ein Übergangsmaterial aus irgendeinem der III-V-Verbindungshalbleiter auf der Basis von As, P, N, Sb zusammengesetzt ist, die den Beschränkungen unterliegen, dass der Gitterparameter in der Ebene größer oder gleich dem der oberen Subzelle (A) und kleiner oder gleich dem der mittleren Subzelle (B) ist und eine Bandlückenenergie größer als die der Basis (112) der mittleren Subzelle (B) ist und die Bandlücke der Zwischenschicht (116) bei etwa 1,50 eV konstant bleibt.

7. Verfahren nach Anspruch 5, wobei die mittlere Subzelle (B) aus einer GaInP-, GaAs-, GaInAs-, GaAsSb- oder GaInAsN-Emitterregion (111) und einer GaAs-, GaInAs-, GaAsSb- oder GaInAsN-Basisregion (112) zusammengesetzt ist.

**Revendications**

1. Une cellule solaire multijonction comprenant:

une première sous-cellule (A) solaire supérieure comportant un émetteur (106) et une base (107), les deux ayant une première bande interdite et étant composés d'InGa(Al)P,
une seconde sous-cellule (B) solaire centrale adjacente à ladite première sous-cellule (A) solaire supérieure et ayant un émetteur (111) d'hétérojonction d'InGaP et une base (112) de GaAs ou $In_{0,015}GaAs$, ayant une bande interdite de 1,2 à 1,6 eV, dans laquelle l'émetteur de la sous-cellule (B) solaire centrale a aussi une première bande interdite qui est égale à la première bande interdite de l'émetteur de la première sous-cellule supérieure, et

dans laquelle la base (112) de la seconde sous-cellule (B) centrale a une seconde bande interdite qui est plus étroite que la première bande interdite de l'émetteur de la sous-cellule (B) centrale de sorte que ladite sous-cellule (B) centrale est mise en concordance de réseau avec ladite sous-cellule (A) supérieure,

une couche (116) intermédiaire graduée adjacente à ladite sous-cellule (B) solaire centrale, ladite couche (116) intermédiaire graduée ayant une troisième bande interdite supérieure à la seconde bande interdite de ladite base de la sous-cellule (B) centrale; et dans laquelle la couche intermédiaire graduée est composée de $(In_xGa_{1-x})_yAl_{1-y}As$ et a une band interdite constante, dans laquelle la sous-cellule supérieure est disposée sur et est mise en concordance de réseau avec la sous-cellule centrale et a une bande interdite de 1,8 à 2,1 eV ; et

une troisième sous-cellule (C) solaire inférieure adjacente à ladite couche intermédiaire graduée et ayant un émetteur d'hétérojonction (119) et une base (120), dans laquelle l'émetteur de la sous-cellule (C) inférieure a une quatrième bande interdite supérieure à la seconde bande interdite de la base de la sous-cellule (B) centrale, dans laquelle ladite sous-cellule inférieure est composée d'une base d'InGaAs et d'un émetteur d'InGaP mis en concordance de réseau avec la base,

dans laquelle la base de la sous-cellule inférieure a une bande interdite de 0,8 à 1,2 eV,

la base de la sous-cellule centrale a une bande interdite de 1,2 à 1,6 eV, et la sous-cellule supérieure est disposée sur et mise en concordance de réseau avec la sous-cellule centrale et a une bande interdite de 1,8 à 2,1 eV,

dans laquelle la cinquième bande interdite de la base de la sous-cellule (C) inférieure est

a) plus étroite que la quatrième bande interdite de l'émetteur de la sous-cellule (C) inférieure, et

b) plus étroite que la seconde bande interdite de la base de la sous-cellule (B) centrale de telle sorte que ladite sous-cellule (C) inférieure présente un réseau différent de ladite sous-cellule (B) centrale.

**2.** La cellule solaire multijonction selon la revendication 1, dans laquelle la couche (116) intermédiaire graduée est graduée en fonction de la composition pour être mise en concordance de réseau avec la sous-cellule (B) centrale d'un côté et avec la sous-cellule (C) inférieure de l'autre côté.

**3.** La cellule solaire multijonction selon la revendication 1, dans laquelle ladite couche (116) intermédiaire graduée est composée de l'un quelconque des semi-conducteurs composés III-V à base de As, P, N, Sb soumis aux contraintes consistant à avoir le paramètre de réseau dans le plan supérieur ou égal à celui de la sous-cellule (B) centrale et inférieur ou égal à celui de la sous-cellule (C) inférieure, et ayant une énergie de bande interdite supérieure à celle de la base (112) de la sous-cellule (B) centrale.

**4.** La cellule solaire multijonction selon l'une ou plusieurs des revendications précédentes, dans laquelle ladite sous-cellule (C) inférieure est disposée sur un substrat (125) choisi parmi le groupe de saphir, GaAs, Ge ou Si et est liée audit substrat par un adhésif (124).

**5.** Un procédé de fabrication d'une cellule solaire multijonction selon la revendication 1 comprenant:

fournir un premier substrat (101);
déposer sur un premier substrat (101) une séquence de couches de matériau semi-conducteur formant une cellule solaire comprenant au moins une jonction base-émetteur formant une hétérojonction;
monter un substrat de substitution (125) sur la séquence de couches; et
retirer le premier substrat (101).

**6.** Le procédé selon la revendication 5, dans lequel ledit matériau de transition est composé de l'un quelconque des semi-conducteurs composés III-V à base de As, P, N, Sb soumis aux contraintes consistant à avoir le paramètre de réseau dans le plan supérieur ou égal à celui de la sous-cellule (A) supérieure et inférieur ou égal à celui de la sous-cellule (B) centrale, et avoir une énergie de bande interdite supérieure à celle de la base (112) de la sous-cellule (B) centrale, et la bande interdite de la couche intermédiaire (116) reste constante à environ 1,50 eV.

**7.** Le procédé selon la revendication 5, dans lequel ladite sous-cellule (B) centrale est composée d'une région (111) d'émetteur de GaInP, GaAs, GaInAs, GaAsSb ou GaInAsN et d'une région (112) de base de GaAs, GaInAs, GaAsSb ou GaInAsN.

FIG.1

| | | |
|---|---|---|
| p++ GaInAs | p+ Contact | 122 |
| GaInP | BSF | 121 |
| p GaInAs | p base | 120 |
| n− GaInAs | n+ emitter | 119 |
| n+ GaInP | window | 118 |
| n+ GaInP | barrier layer | 117 |
| n− InGaAlAs | metamorphic buffer layer | 116 |
| n− GaInP | barrier layer | 115 |
| AlGaAs p++/GaAs n++ | p++/n++ tunnel diode | 114 |
| p+ GaInP$_2$ | BSF | 113 |
| p GaAs | p base | 112 |
| n+ GaInP$_2$ | n+ emitter | 111 |
| n+ InAlP$_2$ | window | 110 |
| AlGaAs p++/InGaP n++ | p++/n++ tunnel diode | 109 |
| p+ AlGaInP | BSF | 108 |
| p GaInP$_2$ | p base | 107 |
| n+ GaInP$_2$ | n+ emitter | 106 |
| n+ AlInP$_2$ | window | 105 |
| n++ GaAs | contact layer | 104 |
| n+ GaInP$_2$ | etch stop layer | 103 |
| GaAs | buffer layer | 102 |
| GaAs | Substrate | 101 |

cell C — layers 120, 119

cell B — layers 112, 111

cell A — layers 107, 106

# FIG.2

| | | |
|---|---|---|
| | | 123 |
| | | 122 |
| p++ GaInAs | p+ Contact | 121 |
| GaInP | BSF | |
| p GaInAs | p base | 120 |
| n− GaInAs | n+ emitter | 119 |
| n+ GaInP | window | 118 |
| n+ GaInP | barrier layer | 117 |
| n− InGaAlAs | metamorphic buffer layer | 116 |
| n− GaInP | barrier layer | 115 |
| AlGaAs p++/GaAs n++ | p++/n++ tunnel diode | 114 |
| p+ GaInP$_2$ | BSF | 113 |
| p GaAs | p base | 112 |
| n+ GaInP$_2$ | n+ emitter | 111 |
| n+ InAlP$_2$ | window | 110 |
| AlGaAs p++/InGaP n++ | p++/n++ tunnel diode | 109 |
| p+ AlGaInP | BSF | 108 |
| p GaInP$_2$ | p base | 107 |
| n+ GaInP$_2$ | n+ emitter | 106 |
| n+ AlInP$_2$ | window | 105 |
| n++ GaAs | contact layer | 104 |
| n+ GaInP$_2$ | etch stop layer | 103 |
| GaAs | buffer layer | 102 |
| GaAs | Substrate | 101 |

cell C — layers 120, 119, 118
cell B — layers 113, 112, 111
cell A — layers 107, 106

## FIG.3

| | | |
|---|---|---|
| | adhesive | —124 |
| | | —123 |
| | ///////////////////////// | —122 |
| | p+ contact | —121 |
| | BSF | |
| cell C | p base | —120 |
| | n+ emitter | —119 |
| | window | —118 |
| | barrier layer | —117 |
| | metamorphic buffer layer | —116 |
| | barrier layer | —115 |
| | p++/n++ tunnel diode | —114 |
| | BSF | —113 |
| cell B | p base | —112 |
| | n+ emitter | —111 |
| | window | —110 |
| | p++/n++ tunnel diode | —109 |
| | BSF | —108 |
| cell A | p base | —107 |
| | n+ emitter | —106 |
| | window | —105 |
| | contact layer | —104 |
| | etch stop layer | —103 |
| | buffer layer | —102 |
| | Substrate | —101 |

FIG.4

| | | |
|---|---|---|
| | Surrogate Substrate | —125 |
| | adhesive | —124 |
| | ////////////////////////////////////////// | —123 |
| | | —122 |
| | p+ contact | —121 |
| cell C | BSF | |
| | p base | —120 |
| | n+ emitter | —119 |
| | window | —118 |
| | barrier layer | —117 |
| | metamorphic buffer layer | —116 |
| | barrier layer | —115 |
| | p++/n++ tunnel diode | —114 |
| | BSF | —113 |
| cell B | p base | —112 |
| | n+ emitter | —111 |
| | window | —110 |
| | p++/n++ tunnel diode | —109 |
| | BSF | —108 |
| cell A | p base | —107 |
| | n+ emitter | —106 |
| | window | —105 |
| | contact layer | —104 |
| | etch stop layer | —103 |
| | buffer layer | —102 |
| | Substrate | —101 |

FIG.5A

| | | |
|---|---|---|
| Surrogate Substrate | | 125 |
| adhesive | | 124 |
| | | 123 |
| | | 122 |
| p+ contact | | 121 |
| BSF | | |
| p base | | 120 |
| n+ emitter | | 119 |
| window | | 118 |
| barrier layer | | 117 |
| metamorphic buffer layer | | 116 |
| barrier layer | | 115 |
| p++/n++ tunnel diode | | 114 |
| BSF | | 113 |
| p base | | 112 |
| n+ emitter | | 111 |
| window | | 110 |
| p++/n++ tunnel diode | | 109 |
| BSF | | 108 |
| p base | | 107 |
| n+ emitter | | 106 |
| window | | 105 |
| contact layer | | 104 |
| etch stop layer | | 103 |
| buffer layer | | 102 |

cell C
cell B
cell A

## FIG.5B

| | | |
|---|---|---|
| | buffer layer | 102 |
| | etch stop layer | 103 |
| | contact layer | 104 |
| | window | 105 |
| cell A | n+ emitter | 106 |
| | p base | 107 |
| | BSF | 108 |
| | p++/n++ tunnel diode | 109 |
| | window | 110 |
| cell B | n+ emitter | 111 |
| | p base | 112 |
| | BSF | 113 |
| | p++/n++ tunnel diode | 114 |
| | buffer layer | 115 |
| | metamorphic buffer layer | 116 |
| | buffer layer | 117 |
| | window | 118 |
| cell C | n+ emitter | 119 |
| | p base | 120 |
| | BSF | 121 |
| | p+ contact | 122 |
| | | 123 |
| | adhesive | 124 |
| | Surrogate Substrate | 125 |

FIG.5C

| | |
|---|---|
| etch stop layer | 103 |
| contact layer | 104 |
| window | 105 |
| . . . | |
| | 123 |
| //////////// | |
| adhesive | 124 |
| Surrogate Substrate | 125 |

FIG.6

| | |
|---|---|
| contact layer | —104 |
| window | —105 |

.
.
.

—123

adhesive —124

Surrogate Substrate —125

# FIG.7

501

contact layer ——— 104
——— 105
window

.
.
.

123

adhesive ——— 124

Surrogate Substrate ——— 125

FIG.8

501

104

104

window — 105

123

adhesive — 124

Surrogate Substrate — 125

FIG.9

FIG.10A

500

cell 1

cell 3

cell 2

cell 4

FIG.10B

501

104                                         104         130

window                                                  105

·
·
·

123

adhesive                                                124

Surrogate Substrate                                     125

FIG.11

FIG.12

FIG.13

130    501    510

104    104

105    window

123

metal

adhesive
124    Surrogate Substrate

125a

FIG.14A

FIG.14B

**FIG.15**

FIG.16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20070277873 A1
- US 7071407 B, Fatemi

- US 20090078309 A1
- US 20090155952 A1

**Non-patent literature cited in the description**

- Lattice Mismatched Approaches for High Performance, III - V Photovoltaic Energy Converters. **M.W. WANLESS et al.** Conference Proceedings of the 31st IEEE Photovoltaic Specialists Conference. IEEE Press, 03 January 2005